# EUROPEAN PATENT SPECIFICATION

(11) **EP 3 730 952 B1**
(45) Date of publication and mention of the grant of the patent: **14.06.2023**
(21) Application number: 19171171.2
(22) Date of filing: 25.04.2019
(51) Int. Cl.: G01R 31/12, H02B 13/065

(54) **DARK DISCHARGE DIAGNOSIS**
DUNKELENTLADUNGSDIAGNOSE
DIAGNOSTIC DE DÉCHARGE OBSCURE

(43) Date of publication of application: 28.10.2020
(73) Proprietor: Hitachi Energy Switzerland AG, 5400 Baden (CH)
(72) Inventor: Simka, Philipp, 5610 Wohlen (CH); Teppati, Valeria, 8112 Otelfingen (CH)
(74) Representative: Michalski Hüttermann & Partner Patentanwälte mbB

(56) References cited:
- CN-A- 108 169 640
- US-A1- 2012 032 686
- BRAUN J M ET AL: "Reliability of GIS EHV epoxy insulators: the need and prospects for more stringent acceptance criteria", PROCEEDINGS OF THE POWER ENGINEERING SOCIETY TRANSMISSION AND DISTRIBUTION CONFERENCE. DALLAS, SEPT. 22 - 27, 1991; [PROCEEDINGS OF THE POWER ENGINEERING SOCIETY TRANSMISSION AND DISTRIBUTION CONFERENCE], NEW YORK, IEEE, US, vol. -, 22 September 1991 (1991-09-22), pages 467-472, XP010053797, DOI: 10.1109/TDC.1991.169546 ISBN: 978-0-7803-0219-8
- HALLER R ET AL: "HIGH-VOLTAGE FIELD TESTING OF GIS FROM A PHYSICAL VIEW-POINT", PROCEEDINGS OF THE INTERNATIONAL CONFERENCE ON PROPERTIES AND APPLICATIONS OF DIELECTRIC MATERIALS. BEIJING, SEPT. 12 - 16, 1988; [PROCEEDINGS OF THE INTERNATIONAL CONFERENCE ON PROPERTIES AND APPLICATIONS OF DIELECTRIC MATERIALS], NEW YORK, IEEE, US, vol. 2, 12 September 1988 (1988-09-12), pages 746-749, XP000075944,

## Description

### FIELD OF INVENTION

The invention is on the field of particle detection in high-voltage devices, specifically in so called Gas Insulated Switchgears (GIS). More specifically, the invention aims at identifying contaminations of different particle sizes and different kinds of particles within the housing of a Gas Insulated Switchgear (GIS). In particular, embodiments of the present disclosure relate to a method and a device for measuring and diagnosing such particle contamination with a measurement of so-called Dark Discharge.

### BACKGROUND OF INVENTION

The design for Gas Insulated Switchgear (GIS) relies on the accurate prediction of an electric field. The latter, in turn, is determined in first approximation by an applied voltage, shape and distance of electrodes, as well as the properties of the materials arranged between the electrodes.

Many factors, such as presence of metal or insulating particles, microscopic defects on surfaces, volume or surface charges on dielectric materials/coatings lead to a deviation of the electric field from standard field models.

One of the most relevant "distortions" in HVDC insulation applications (or for AC systems in case DC field components are present, e.g. disconnector switching or capacitive switching with HV circuit breakers) is surface charge accumulation on highly resistive dielectric materials.

It is known that under DC high voltage application, extremely small currents in the pico-Ampere (pA) range (1pA=1E-12A) are generated.

These currents appear for voltage levels below partial discharge inception level and, consequently, also far below breakdown inception, in a so-called Dark Discharge regime. Dark Discharge means, that this effect does not produce any visible effects like arcs or glow effects.

In the Dark Discharge regime, even if so small, such currents represent the main source of charges which continuously accumulate on highly resistive dielectric surfaces. Thereby, a constant polarity of the applied voltage is assumed which means no AC-voltage.

The most relevant physical processes which can provoke or impact these pre-breakdown currents may be thermionic and field emission, wherein electrons are emitted by a metallic cathode (bare surface).

This mechanism strongly depends on field enhancement at micro-protrusions on the surface, like discharges from a sharp or pointed object in a strong electric field and, in general, on its characteristics (e.g. type of metal, roughness, paint, cleanliness).

In presence of a gas, ionization by cosmic radiation produces free electrons and positive SF6 ions. If the electron is attached by another SF6 molecule, an ion pair (IP) is formed.

This process is usually referred to as natural ionization and is typically between 20 and 50 IP/(s·cm3), dependent on geographic location and gas pressure. This process happens independently of voltage application.

The opposite process, an ion-ion recombination, i.e. charge-neutralizing collisions between charge carriers (ions) of opposite polarity, tends to bring the gas back to its neutral state.

Typical processes that depend on the presence of an electric field are for example:
- collision triggered ionization: a free electron and a positive SF6 ion are created
- collisional attachment: a free electron is attached to an SF6 molecule, creating SF6
- collisional detachment: free electrons can again be released from SF6.

These mechanisms may also be dependent on gas properties like the type of gas, pressure of the gas or its temperature.

Another current generation mechanism is called electrophoresis. Dielectric or metal particles may accumulate charges when in contact with a metallic electrode. Consequently, these particles are accelerated towards the electrode of opposite polarity. When they reach the opposite electrode, the process may be reversed, leading to a net current in the system.

This mechanism may depend on surface characteristics and status like roughness, presence of paint, cleanliness, and, of course, the type and amount particle contamination.

Furthermore, the process depends on gas characteristics such as pressure, type of gas, humidity content, and electric field.

Currently, for high voltage apparatuses, generally a so-called "Partial-Discharge"-Measurement (PD) is the only non-destructive diagnosis technique to identify problems in insulations.

The detection of contaminations in GIS is solved by competitors by standardized and commonly known Partial-Discharge Measurement Techniques, which are insensitive and difficult to use under DC-Conditions. Partial Discharge (PD) measurement is measurement method, widely used and the main measurement techniques (Coupling Capacitor or UHF) are described by the IEC-standard. It has a low sensitivity and can only detect defects which exhibit pulsed discharges and can therefore not serve to evaluate the current problems.

A PD analysis can point to a contamination in the insulation material. But it is not possible to locate a small contamination, like small particles (dust, filaments (e.g. cotton), metal, humidity) in the beginning.

Since the currently employed PD technology cannot be used to reliably detect small contaminations, caused by particles, in GIS, there is a demand to detect such a contamination of small particles, causing problems during operation in a Gas insulated Switchgear. In particular, such contaminations shall be detected preferably before installing such Switchgear, since failure detection in a once installed GIS is complex and costly.

J. M. Braun el al. describe "Reliability of GIS EHV epoxy insulators: the need and prospects for more stringent acceptance criteria" in Proceedings of the 1991 IEEE Power Engineering Society Transmission and Distribution Conference, Dallas, Sept. 22 - 27, 1991.

R. Haller et al. describe "High-Voltage Field Testing Of GIS From A Physical ViewPoint" in Proceedings of the International Conference on Properties and Applications of Dielectric Materials, Beijing, Sep. 12 - 16, 1988.

US 2012/032686 A1 describes a voltage source for calibrating a fast transient voltage measurement system, comprising a DC high voltage power supply, a discharging gap, a high voltage conductor and an earthing conductor, wherein the high voltage conductor and the earthing conductor are high voltage insulated from each other and form a traveling wave line with constant wave impedance; the DC high voltage power supply is connected between the ends of the high voltage conductor and the earthing conductor; the discharging gap is connected between ends of the high voltage conductor and the earthing conductor; the discharging gap is broken down when the charging voltage on the high voltage conductor is risen to a certain amplitude.

### SUMMARY OF INVENTION

The invention is defined by the features of the independent claim. Preferred embodiments are defined by the features of the dependent claims.

In order to address the foregoing and other potential problems, embodiments of the present disclosure propose:

In a first aspect, a method for diagnosing a health status of a Gas Insulated Switchgear as defined in independent claim 1 is disclosed.

In another aspect, a measuring device for determining a health status in a Gas insulated switchgear as defined in independent claim 12 is disclosed.

### BRIEF DESCRIPTION OF DRAWINGS

Embodiments of the present disclosure will be presented in the sense of examples and their advantages are explained in greater detail below, with reference to the accompanying drawings, wherein:
FIG. 1 shows a voltage/current behaviour in different discharge regimes for gaseous insulation;
FIG. 2 shows a more detailed sketch of a measurement arrangement according to embodiments of the application;
FIG. 3 shows embodiments of the measuring method according to the present application
FIG. 4 exemplarily shows a power device in form of a Switchgear.

### DETAILED DESCRIPTION OF EMBODIMENTS

Hereinafter, the principle of the present disclosure will be described with reference to the illustrative embodiments. It should be understood, all these embodiments are given merely for the skilled in the art to better understand and further practice the present disclosure, but not for limiting the scope of the present disclosure. For example, features illustrated or described as part of one embodiment may be used with another embodiment to yield still a further embodiment.

In the interest of clarity, not all features of an actual implementation are described in this specification. It will of course be appreciated that in the development of any such actual embodiment, numerous implementation-specific decisions should be made to achieve the developers' specific goals, such as compliance with system-related and business-related constraints, which will vary from one implementation to another. Moreover, it will be appreciated that such a development effort might be complex and time-consuming, but would nevertheless be a routine undertaking for those of ordinary skill in the art having the benefit of this disclosure.

The disclosed subject matter will now be described with reference to the attached figures. Various structures, systems and devices are schematically depicted in the drawings for purposes of explanation only and so as to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art.

No special definition of a term or phrase, i.e. a definition that is different from the ordinary and customary meaning as understood by those skilled in the art, is intended to be implied by consistent usage of the term or phrase herein. To the extent that a term or phrase is intended to have a special meaning, i.e. a meaning other than that understood by skilled artisans, such a special definition will be expressly set forth in the specification in a definitional manner that directly and unequivocally provides the special definition for the term or phrase.

The present application may disclose an analysis approach to measure Partial Discharge (PD), in particular Dark Discharge in order to evaluate problems and status of insulation systems. "Dark Discharge Diagnosis" uses a radically different measurement approach which has much higher sensitivity and solves the issue of detecting continuous discharges.

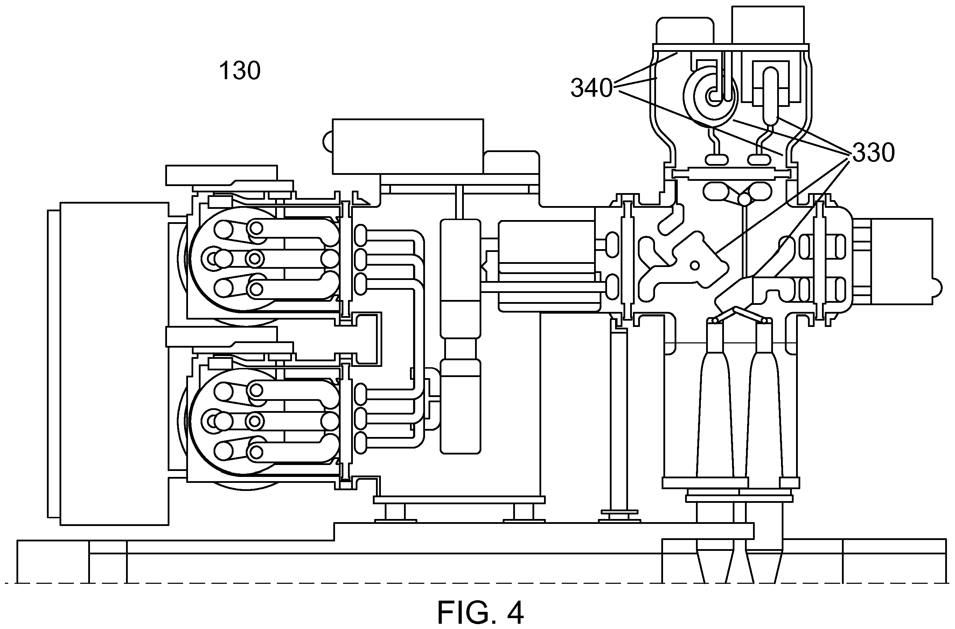

The present application may therefore provide an approach to quantify charge carriers in high voltage Gas Insulated Switches (GIS; in SF6) at electric fields with relatively low field-strength (i.e. 0 to 2 kV/mm). A pressure vessel, a high-voltage DC source 100 and a low-pass DC-current measurement 110, 120 may be used to do so (see FIG. 4). The vessel in FIG. 4 is exemplary for a switchgear, in particular a Gas Insulated Switchgear.

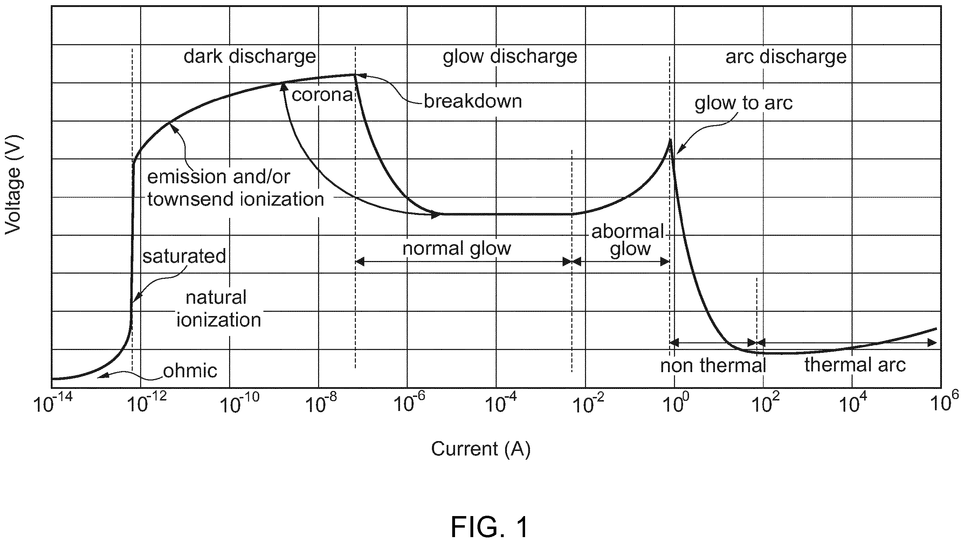

Standard physical models like natural ionization, electrode field emission or Townsend ionization (see overview over different discharge regimes in FIG. 1) cannot explain the present current measurements. Therefore, alternative explanations have been searched.

An explanation therefore may be, that the currents have to do with contaminations in the GIS (within the GIS) which are influenced by high DC voltages.

The technical solution to identify contamination/defects in gas insulated equipment (like GIS) is the excitation of the system (i.e. particles in the switchgear or other power devices in which it may be important to identify contaminations) with a DC voltage, in the range of the rated voltage of the equipment or below. A current flow, as a result of the excitation may be determined by a corresponding (sensitive) direct current measurement.

The proposed "Dark Discharge Diagnosis" according to the present application may consist of a High Voltage DC Power Supply 100, with a voltage rating around the rated voltage of the equipment under test (DUT) and a sensitive direct current measurement device.

High voltage low pass filters may be installed to improve quality of measured signals. Since all external electrical disturbances have a certain frequency content, they may be filtered for the low-pass measurement which may then give then an advantageous signal to noise (SNR)-ratio.

The equipment may have a certain 'leakage' current which is due to the solid dielectric material in the GIS. This current level needs to be set as "healthy threshold". Any current level above will be an indication of a contamination (dielectric, metallic particles, humidity). By changing the current return path, compartments holding a contamination can be localized.

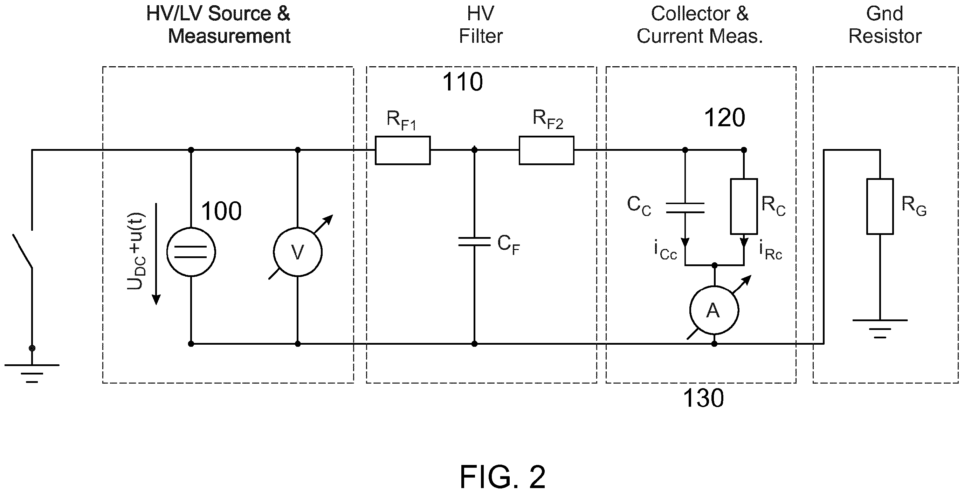

In a first embodiment, the present application may therefore disclose a method for diagnosing a "health status" of a power device 130. In this respect, see FIG. 2, the method may comprise to apply a DC-high-voltage 100 at first connection points on the power device 130, to apply charges on surfaces 330, 340 within the power device, represented by item 130.

The method may further comprise to determine a leakage current level, which may be related to a dielectric within the power device. The leakage current level may be set as a threshold current level.

The leakage current may not be frequency dependent. The method preferably measures a "smoothed" DC current.

A "clean" system, i.e. a system without contaminations of particles 300 may always have a certain leakage current by a natural "migration" of charges by the contained insulation gas (e.g. SF6) and the solid insulation material. This level of leakage current can be measured or calculated to recognize deviations from it. A "clean" system may have a leakage current in the range of some pico Ampere (pA).

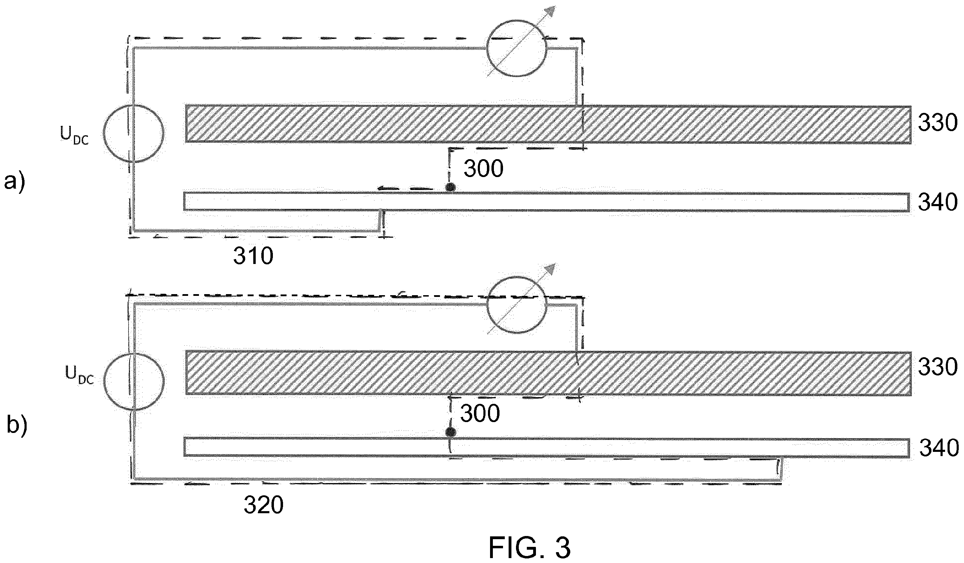

A current measuring device 120 may be connected at second connection points at the power device 130, wherein a path between the second connection points may form a first current return path, also shown in FIG. 3. A first current, flowing over the first current return path, may be measured and a first contamination related to the height of the current over the first current return path may then be identified.

The high-voltage DC source charges not only the surfaces of the power device 130. Also particles, contained within the power device 130 and preferably in contact with the surfaces, are charged, in principle as it is with particles 300 between condenser surfaces.

In case the electrostatic force of attraction on the charged particles, e.g. 300 in FIG. 3, in the applied electric field becomes bigger than the force of gravity, the charged particles 300 may start to move to a surface with an opposed electrical potential and the charges on the particles 300 recombine at the opposed potential (e.g. an oppositely charged surface).

Once discharged at the counter pole, the particles, like particle 300 in FIG. 3a/b may fall back to the other electrode, due to the force of gravity. Having reached the other electrode, the process begins again. This may recur continuously. The continuous charging/discharging of particles 300 generates a very small current which may be measured.

Preferably, the electrodes (poles/counter-poles) are arranged in a way that discharged particles 300 fall back to their starting point. This means that the surfaces 330, 340 of the electrodes are substantially parallel to ground.

In another embodiment of the method for diagnosing a health status of a power device 130, the power device 130 which is measured, may be preferably a Gas Insulated Switchgear (GIS).

Preferably, the method is used in a production process of a Gas Insulated Switchgear. Contaminations, detected during production or assembly, save huge efforts in avoiding costly power plant shutdowns, when contaminated compartments of a switchgear may fail.

The method for diagnosing a health status of a power device 130 may further comprise to connect the current measuring device to third connection points and set these third connection points as a second current return path 310, 320, as shown in FIG. 3.

A second current, flowing over the second current return path 320 may then be measured and a second contamination 300, related to the height of the current over the second current return path may then be identified.

Depending on the size of the contaminating particles 300 (metallic, humidity, dust etc.) the value of the current changes. Since it is possible to resolve the movement of dust (some 10µm particles) with the setup, it may be assumed, that also larger particles (some 100µm), which may pose a major threat in Gas Insulated Switchgear 130 (GIS, DUT: Device Under Test), may be detected with the disclosed method.

In case of metallic contamination (particles 300), much higher current values compared to the leakage currents may be expected. The method may also require to sweep the high-voltage 100. Since it is not known, how big the particles 300 in the containment (GIS) are and of what material (e.g. particles can be filament, aerosol droplets, metal dust, etc).

For example, larger metal particles (e.g. 100um) may need a higher electrostatic field to get them moving from one electrode surface to the second electrode to get discharged. Metal particles are much heavier, compared to e.g. cotton filaments or dust from cleaning material or environmental air.

It may be expected, that metal particles discharging on the adversely charged counter-pole may cause a considerably higher current at a higher voltage. This is, such a correlation may be indicative of metal particles.

The different current paths, e.g. the first and second current path, may be represented by different compartments in the power device 130. Different current-return paths improve the measuring result of the disclosed method for diagnosing a health status of a power device 130. The applied voltage generally would allow for a general detection of a contamination in the power device 130. In other words, it can be stated if a contamination with particles 300 is present in the power device 130.

But it is also advantageous to know, where the contamination within the power device 130 is located, since the physical dimensions of such a device are in the range of several meters.

To assess, where the contamination, or better where the source of the particles 300 is located in the power device 130, the measurement method may be used with different current return-paths.

FIG. 4 shows exemplary a power device 130 (Gas Insulated Switchgear). The current-return path denotes the connection from the measured object (surfaces/electrodes 340, 330) through the current measuring device and back to the high-voltage source 100 (not shown here).

One can have at least two of such paths, e.g. at a first end and at a second end of the power device 130. By toggling between the two paths, a timely delay may be measured between the currents over the current paths. The timely delay of incoming (measured) currents is indicative from which location in the power device 130 the current stems. This is also the source of the contamination. In other words, the origin of the current may be indicative of the source of the contamination 300.

Reference number 330 in FIG. 3a/b may represent/denote a first surface in the interior of the Gas Insulated Switchgear, reference number 340 may represent/denote a second surface in the interior of the Gas Insulated Switchgear. In particular, 340 may be the inner (metallic) surface of a housing of a switchgear and 330 may be the surface of a switch or another metallic surface of devices inside the switchgear. Surfaces 330 and 340 have no electrical connection between them.

Broken lines 310 and 320 in FIGs. 3a and 3b represent different current return paths 310, 320 with a different length each. Item 300 may represent a single particle. If particle 300 (charged) travels from the first to the second electrode, the particle 300 may be discharged in the moment when particle 300 comes in contact with the second surface 330 (counter-pole, adversely charged electrode).

The very small discharge current may now flow over one of the two different paths back to the high voltage source. The paths can be toggled. Since both paths have a different length, the currents would need more time to travel over the longer path 320 than over the shorter path 310. This time difference can be measured. By the measured time difference *dt,* it may be possible to have an indication, where the contamination may be located in the GIS.

In one embodiment of the method for diagnosing a health status of a power device 130, the measured currents in the different return paths may be filtered with a specifically designed low-pass filter. This may serve to remove disturbing frequencies, in particular background noise, "ripples", HF noise or 50Hz spurious, unwanted signals.

Theoretically, the current would be kind of "pulse-shaped", wherein the pulses may occur by recombination (displacement current; the arrangement in principle has characteristics of a capacitor) of charges on the counter-pole. A time-resolved measurement would not enable to distinguish it from background noise.

Therefore, the input voltage (High-Voltage source 100) and the output current (the current measured in the return paths 320, 310) are filtered with a filter/integrator 110 (see FIG. 2) in a way that ripples/peaks are removed from the current signal and only a DC-current is measurable.

In one embodiment of the disclosed method, the number of the return paths may relate to the number of different compartments in the power device 130. The different compartments may be measured with the disclosed method before assembling.

Further, in another embodiment, the method according to previous embodiments may comprise to assign a specific contamination, which may be present in the compartments of the power device 130, to a specific current, measured over the current return paths 310, 320.

In other words, a specific current, which is measured over the different current return paths 310, 320, may be indicative of a specific contamination 300 in a compartment of the power device 130. This means, that a current may represent the presence of dust, particularly dust particles 300 in the compartment.

Other current values may represent the presence of humidity in the compartment of the Gas Insulated Switchgear or metallic particles 300 or particles stemming from the inner surfaces of the power device 130.

In another aspect, a measuring device comprising a measuring equipment may be disclosed. The measuring equipment in the measuring device may be configured to determine a health status in a power device 130, e.g. a Gas Insulated Switchgear. The measuring device may be construed such that it can perform the measuring steps according to the method presented in previous embodiments.

To summarize, the embodiments of the disclosed application relate in general to a measuring method to recognize a particle contamination in a containment. The containment may be the interior of a high voltage switch, in particular the interior of a Gas Insulated Switchgear (GIS), as exemplary shown in FIG. 4.

Due to the high electrical field strength in the containment, when connected to a high-voltage power grid, particles 300 remaining in the Gas Insulated Switchgear from manufacturing the same or also from a cleaning process (filaments from the cleaning equipment), may negatively influence the electrical field distribution. This may lead to an undesired arcing within the Gas Insulated Switchgear during operation.

When such a switch is installed in the field (e.g. power plant) and it is determined, during operation, that contaminating particles 300 may be present in the Gas insulated Switchgear, the plant or at least the part, in which the Switchgear is installed has to be shut down.

Contaminations can enter into the Gas Insulated Switchgear or into the housing of other power device 130s on many occasions. One of the most likely occasions, where the interior can be contaminated, may be the production process, where the different parts of the GIS are produced and assembled.

Even if the interior of the switchgear is thoroughly cleaned, dust particles, residual humidity or metal particles from the production process may remain in the switchgear. The number of particles may be very small, but even a small number of particles 300 may negatively influence the electrical field. Since the Switchgear may have quite huge dimensions, it is not likely to detect the contaminations visually.

The method which has previously been disclosed, may therefore serve as a very advantageous method to test Switchgears before installing them in power plants and may save unnecessary maintenance efforts.

Firstly, with the disclosed method it can be detected if any contaminations are within the GIS at all. For this, a high DC voltage is connected to the switchgear in such a way, that particles 300, which are assumed to be on conductive surfaces within the GIS, are charged (collecting electrons on the surface of a contaminating particle).

Loaded particles 300 may start travelling, driven by the electrostatic force, from one electrode to the adversely charged electrode (from one surface within the GIS to another surface within the GIS). The particles 300 move against the force of gravity. Electrostatic force and adversely directed force of gravity are both affecting the particle. When the particle discharges on the other electrode (charged surface within the Gas Insulated Switchgear), it is forced back by the force of gravity to its "starting" point.

This charging/discharging process recurs and gives a more or less constant stream of pulses, filtered and measurable as a DC current.

Secondly, the method provides also the possibility to determine a location of contamination by choosing different current return paths for the measured current. Time differences in the current pulses, due to different path-length, enable a localization of contaminations in the Gas insulated Switchgear which eases cleaning during production or assembly.

## Claims

1. A method for diagnosing a health status of a Gas Insulated Switchgear (130), the method comprising:
a) applying a DC-high-voltage at first connection points on the Gas Insulated Switchgear to apply charges on surfaces within the Gas Insulated Switchgear (130);
b) connecting a current measuring device at second connection points at the Gas Insulated Switchgear (130), wherein a path between the second connection points is as a first current return path (310);
c) measuring a first current, flowing over the first current return path (310);
d) determining a leakage current level, related to charges within the Gas Insulated Switchgear (130), and setting the leakage current level as a threshold current level;
e) replacing the Gas Insulated Switchgear (130) by another Gas Insulated Switchgear (130); and repeating a) to c);
identifying a first contamination in the Gas Insulated Switchgear (130), from a relation of the threshold current level determined in step d) and the height of the current over the first current return path.

2. The method according to the previous claim further comprises
connecting the current measuring device to third connection points and set these third connection points as a second current return path (320);
measuring a second current, flowing over the second current return path (320) and identifying a second contamination (300), related to the height of the current over the second current return path (320).

3. The method according to any of the previous claims further comprising:
toggling between the first and the second current return paths (310, 320) to measure a timely delay between the first and the second current over the current paths (310, 320), wherein the timely delay of measured currents is indicative of the location of the origin of the current in the device.

4. The method according to any of the previous claims, wherein the current return paths (310, 320) are represented by different compartments in the Gas insulated switchgear (130).

5. The method according to any of the previous claims, wherein the currents in the return paths (310, 320) are filtered with a low-pass filter (110) to remove frequencies from the measured current signals from the current return paths (310, 320).

6. The method according to any of the previous claims, wherein the number of the return paths (310, 320) relates to the number of different compartments in the Gas insulated switchgear (130).

7. The method according to any of the previous claims, wherein a voltage rating of the DC High-voltage less or equal to a voltage rating of the Gas insulated switchgear (130).

8. The method according to any of the previous claims, further comprising:
assigning a specific contamination in the compartments of the Gas insulated switchgear (130) to a current value, measured over the current return paths (310, 320).

9. The method according to any of the previous claims, wherein the contaminations in the compartments of the Gas insulated switchgear (130) are one or more of the group: humidity, dust particles, metal particles.

10. The method according to claim 1, wherein the leakage current level is related to a natural migration of the charges by a contained insulation gas and/or solid insulation material.

11. The method according to claim 1, wherein the Gas Insulated Switchgear (130) in a) is a Gas Insulated Switchgear (130), substantially without contaminations of particles (300) and the Gas Insulated Switchgear (130) in e) is a Gas Insulated Switchgear (130) with contaminations of particles (300)

12. A measuring device for determining a health status in a Gas insulated switchgear (130) comprising
a High voltage DC-source (100);
a low-pass DC current measurement (110) wherein
the measuring device is configured to perform the steps according to method claims 1 to 11.

## Patentansprüche

1. Verfahren zur Diagnose des Gesundheitszustandes einer gasisolierten Schaltanlage (130), wobei das Verfahren Folgendes umfasst:
a) Anlegen einer DC-Hochspannung an den ersten Anschlusspunkten der gasisolierten Schaltanlage, um die Oberflächen innerhalb der gasisolierten Schaltanlage (130) aufzuladen;
b) Anschließen eines Strommessgeräts an zweiten Anschlusspunkten an der gasisolierten Schaltanlage (130), wobei ein Pfad zwischen den zweiten Anschlusspunkten als erster Stromrücklaufpfad (310) ausgebildet ist;
c) Messen eines ersten Stroms, der über den ersten Stromrücklaufpfad (310) fließt;
d) Bestimmen eines Leckstrompegels, der sich auf Ladungen innerhalb der gasisolierten Schaltanlage (130) bezieht, und Festlegen des Leckstrompegels als Schwellenstrompegel;
e) Ersetzen der gasisolierten Schaltanlage (130) durch eine andere gasisolierte Schaltanlage (130); und Wiederholen von a) bis c);
Identifizieren einer ersten Kontamination in der gasisolierten Schaltanlage (130) anhand einer Beziehung zwischen dem in Schritt d) bestimmten Schwellenstrompegel und der Höhe des Stroms über den ersten Stromrücklaufpfad.

2. Verfahren nach dem vorhergehenden Anspruch, das ferner Folgendes umfasst:
Verbinden des Strommessgeräts mit dritten Anschlusspunkten, und Festlegen dieser dritten Anschlusspunkte als zweiten Stromrücklaufpfad (320);
Messen eines zweiten Stroms, der über den zweiten Stromrücklaufpfad (320) fließt, und
Identifizieren einer zweiten Kontamination (300), die mit der Höhe des Stroms über dem zweiten Stromrücklaufpfad (320) zusammenhängt.

3. Verfahren nach einem der vorherige Ansprüche, das ferner Folgendes umfasst:
Umschalten zwischen dem ersten und dem zweiten Stromrücklaufpfad (310, 320), um eine zeitliche Verzögerung zwischen dem ersten und dem zweiten Strom über die Strompfade (310, 320) zu messen,
wobei die zeitliche Verzögerung der gemessenen Ströme ein Hinweis auf den Ort des Stromursprungs in der Vorrichtung ist.

4. Verfahren nach einem der vorhergehenden Ansprüche, wobei die Stromrücklaufpfade (310, 320) durch verschiedene Abteile in der gasisolierten Schaltanlage (130) dargestellt werden.

5. Verfahren nach einem der vorhergehenden Ansprüche, wobei die Ströme in den Rücklaufpfaden (310, 320) mit einem Tiefpassfilter (110) gefiltert werden, um Frequenzen aus den gemessenen Stromsignalen aus den Stromrücklaufpfaden (310, 320) zu entfernen.

6. Verfahren nach einem der vorhergehenden Ansprüche, wobei sich die Anzahl der Rücklaufpfade (310, 320) auf die Anzahl der verschiedenen Abteile in der gasisolierten Schaltanlage (130) bezieht.

7. Verfahren nach einem der vorhergehenden Ansprüche, wobei die Nennspannung der DC-Hochspannung kleiner oder gleich der Nennspannung der gasisolierten Schaltanlage (130) ist.

8. Verfahren nach einem der vorherige Ansprüche, das ferner Folgendes umfasst:
Zuordnen einer bestimmten Kontamination in den Abteilen der gasisolierten Schaltanlage (130) zu einem Stromwert, gemessen über die Stromrücklaufpfade (310, 320) .

9. Verfahren nach einem der vorhergehenden Ansprüche, wobei die Kontaminationen in den Kammern der gasisolierten Schaltanlage (130) eine oder mehrere der folgenden Gruppen sind: Feuchtigkeit, Staubpartikel, Metallpartikel.

10. Verfahren nach Anspruch 1, wobei die Höhe des Leckstroms mit einer natürlichen Migration der Ladungen durch ein enthaltenes Isoliergas und/oder festes Isoliermaterial zusammenhängt.

11. Verfahren nach Anspruch 1, wobei die gasisolierte Schaltanlage (130) in a) eine gasisolierte Schaltanlage (130) ist, die im Wesentlichen keine Kontaminationen von Partikeln (300) aufweist, und die gasisolierte Schaltanlage (130) in e) eine gasisolierte Schaltanlage (130) mit Kontaminationen von Partikeln (300) ist

12. Messgerät zur Bestimmung des Gesundheitszustandes einer gasisolierten Schaltanlage (130), das Folgendes umfasst:
eine Hochspannungs-DC-Quelle (100);
eine Tiefpass-Gleichstrommessung (110), wobei das Messgerät so konfiguriert ist, dass es die Schritte gemäß den Verfahrensansprüchen 1 bis 11 durchführt.

## Revendications

1. Procédé de diagnostic d'un état d'intégrité d'un appareillage de commutation à isolation gazeuse (130), le procédé comprenant les étapes consistant à :
a) appliquer une haute tension CC au niveau de premiers points de connexion sur l'appareillage de commutation à isolation gazeuse pour appliquer des charges sur des surfaces à l'intérieur de l'appareillage de commutation à isolation gazeuse (130) ;
b) connecter un dispositif de mesure de courant au niveau de deuxièmes points de connexion au niveau de l'appareillage de commutation à isolation gazeuse (130), un chemin entre les deuxièmes points de connexion étant comme un premier chemin de retour de courant (310) ;
c) mesurer un premier courant, circulant par le premier chemin de retour de courant (310) ;
d) déterminer un niveau de courant de fuite lié à des charges à l'intérieur de l'appareillage de commutation à isolation gazeuse (130) et définir le niveau de courant de fuite comme un niveau de courant seuil ;
e) remplacer l'appareillage de commutation à isolation gazeuse (130) par un autre appareillage de commutation à isolation gazeuse (130) ; et répéter les étapes a) à c) ;
identifier une première contamination dans l'appareillage de commutation à isolation gazeuse (130) à partir d'une relation entre le niveau de courant seuil déterminé à l'étape d) et la hauteur du courant sur le premier chemin de retour de courant.

2. Procédé selon la revendication précédente, comprenant en outre les étapes consistant à :
connecter le dispositif de mesure de courant à des troisièmes points de connexion et définir ces troisièmes points de connexion comme second chemin de retour de courant (320) ;
mesurer un second courant circulant sur le second chemin de retour de courant (320) et identifier une seconde contamination (300) liée à la hauteur du courant sur le second chemin de retour de courant (320).

3. Procédé selon l'une quelconque des revendications précédentes, comprenant en outre l'étape consistant à :
basculer entre le premier et le second chemin de retour de courant (310, 320) pour mesurer un délai opportun entre le premier et le second courant sur les chemins de courant (310, 320), le délai opportun des courants mesurés indiquant l'emplacement de l'origine du courant dans le dispositif.

4. Procédé selon l'une quelconque des revendications précédentes, dans lequel les chemins de retour de courant (310, 320) sont représentés par différents compartiments dans l'appareillage de commutation à isolation gazeuse (130).

5. Procédé selon l'une quelconque des revendications précédentes, dans lequel les courants sur les chemins de retour (310, 320) sont filtrés avec un filtre passe-bas (110) pour supprimer des fréquences des signaux de courant mesurés des chemins de retour de courant (310, 320) .

6. Procédé selon l'une quelconque des revendications précédentes, dans lequel le nombre des chemins de retour (310, 320) se rapporte au nombre des différents compartiments dans l'appareillage de commutation à isolation gazeuse (130).

7. Procédé selon l'une quelconque des revendications précédentes, dans lequel une tension nominale de la haute tension CC est inférieure ou égale à une tension nominale de l'appareillage de commutation à isolation gazeuse (130).

8. Procédé selon l'une quelconque des revendications précédentes, comprenant en outre l'étape consistant à :
attribuer une contamination spécifique dans les compartiments de l'appareillage de commutation à isolation gazeuse (130) à une valeur de courant, mesurée sur les chemins de retour de courant (310, 320).

9. Procédé selon l'une quelconque des revendications précédentes, dans lequel les contaminations dans les compartiments de l'appareillage de commutation à isolation gazeuse (130) sont une ou plusieurs contaminations du groupe suivant : humidité, particules de poussière, particules métalliques.

10. Procédé selon la revendication 1, dans lequel le niveau de courant de fuite est lié à une migration naturelle des charges par un gaz d'isolation contenu et/ou un matériau d'isolation solide.

11. Procédé selon la revendication 1, dans lequel l'appareillage de commutation à isolation gazeuse (130) à l'étape a) est un appareillage de commutation à isolation gazeuse (130) essentiellement sans contamination de particules (300) et l'appareillage de commutation à isolation gazeuse (130) à l'étape e) est un appareillage de commutation à isolation gazeuse (130) avec contamination de particules (300).

12. Dispositif de mesure permettant de déterminer un état d'intégrité d'un appareillage de commutation à isolation gazeuse (130) comprenant :
une de source CC à haute tension (100) ;
une mesure de courant CC passe-bas (110),
le dispositif de mesure étant configuré pour effectuer les étapes selon les revendications de procédé 1 à 11.
